# EUROPÄISCHE PATENTANMELDUNG

(11) **EP 4 321 656 A1**
(43) Veröffentlichungstag der Anmeldung: **14.02.2024**
(21) Anmeldenummer: 22189397.7
(22) Anmeldetag: 09.08.2022
(51) Int. Cl.: C30B 15/20, C30B 29/06

(54) **VERFAHREN ZUM HERSTELLEN EINES MONOKRISTALLINEN KRISTALLS AUS SILIZIUM**

(71) Anmelder: Siltronic AG, 81677 München (DE)
(72) Erfinder: Balanetskyy, Sergiy, 09599 Freiberg (DE); Gruber, Michael, 84489 Burghausen (DE)

(57) **Zusammenfassung**

Verfahren zum Ziehen eines Kristalls aus Silizium nach dem Czochralski-Verfahren wobei beim Kristallziehen ein erster Kristall durch das Anwenden einer Vorgabekurve auf einer Kristallziehanlage hergestellt wird und der hergestellte erste Kristall einer Messung bezüglich Kristalldefekte unterzogen wird und das Ergebnis der Messung bezüglich Kristalldefekte mit einem gewünschten Messergebnis verglichen wird und anhand der Abweichung des Ergebnis der Messung von einem gewünschten Messergebnis eine neue Vorgabekurve errechnet wird, die für die Herstellung eines weiteren Kristalls dient, dadurch gekennzeichnet, dass für das Errechnen der neuen Vorgabekurve ein Modell verwendet wird, das durch eine Methode des maschinellen Lernens berechnet wurde.

## Beschreibung

Gegenstand der Erfindung ist ein Verfahren zur Herstellung von Kristallen aus Silizium.

Monokristalline Halbleiterscheiben (auch Wafer genannt) sind die Grundlage der modernen Elektronik. Während der Herstellung von Bauelementen auf besagten Halbleiterscheiben werden thermische Prozesse mit mittlerweile recht komplexen Beschichtungsschritten durchgeführt.

Halbleiterscheiben, insbesondere Halbleiterscheiben aus Silizium, werden üblicherweise hergestellt, indem zuerst ein monokristalliner Stab mit Hilfe des sogenannten Float-Zone Verfahrens (FZ) oder des Czochralski Verfahrens (CZ) gezogen wird. Die so produzierten Stäbe werden mittels dafür geeigneter Sägen wie Drahtsägen, Innenlochsägen oder Bandsägen in Kristallstücke geteilt, welche dann üblicherweise in einer Drahtsäge oder Innenlochsäge zu Halbleiterscheiben verarbeitet werden.

Nach weiteren mechanischen, chemo-mechanischen und/oder chemischen Schritten kann optional eine Schicht mittels CVD aufgebracht werden.

Einkristalle -wie zum Beispiel Einkristalle aus Silizium - können beispielsweise eingewachsene Defekte aufweisen, die unerwünscht sind, weil sie die Funktion von elektronischen Bauelementen, die auf Halbleiterscheiben gefertigt aus den Kristallen integriert werden, stören oder sogar den Funktionsausfall solcher Bauteile verursachen können.

Bei solchen Defekten handelt es sich insbesondere um Agglomerate von Punktdefekten, wobei zwischen Leerstellen (vacancies) und Silizium - Zwischengitteratomen (Si-interstitials) unterschieden wird. Geraten solche Punktdefekte in Übersättigung, tendieren sie dazu, Agglomerate zu bilden. Agglomerierte Leerstellendefekte (voids) werden in der Literatur häufig COP-Defekte (crystal originated particles), LPDs (light point defects), LLS (localized light scatterers), LSTD (laser scanning tomography defects) oder FPD (flow pattern defects) genannt.

Im Fall von Silizium -Zwischengitteratomen spricht man von A-Defekten (A-swirldefects) oder Lpit's (large etch pits), falls die Agglomerate wegen ihrer Größe bereits Sekundärdefekte in Form von Versetzungen bilden, und von B-Defekten, falls solche Sekundärdefekte noch nicht auftreten.

Punktdefekte entstehen im Zuge der Herstellung des Einkristalls. Dabei ist das Verhältnis von v/G der Ziehgeschwindigkeit v und des axialen Temperaturgradienten G an der Wachstumsfront des Kristalls die steuernden Parameter.

Liegt das Verhältnis v/G über einem kritischen Wert, dominieren Punktdefekte vom Leerstellen-Typ, während bei einem Verhältnis v/G unter dem kritischen Wert Silizium-Zwischengitteratome überwiegen.

Die theoretische Grundlage hierfür bilden unter anderem Formeln, die von Voronkov et al. (Voronkov, V.V. and Falster, R. (1999) J. Appl. Phys., 86, (11) 5975 und Voronkov, V.V. and Falster, R. (1998) J. Crystal Growth, 194 76) entwickelt wurden. Diese gestatten beispielsweise experimentell verifizierbare Vorhersagen über die Konzentration eingebauter Leerstellen, die Konzentration agglomerierter Leerstellen und die Größe solcher Agglomerate.

Mit zunehmender Integrationsdichte elektronischer Bauelemente und der damit verbundenen Verkleinerung der sie bildenden Strukturen wird die Gegenwart von agglomerierten Leerstellendefekten zum Problem, wenn deren Größe im Bereich der Strukturgröße der Bauelemente liegt.

Um dieses Problem zu lösen, muss das Verhältnis v/G derart kontrolliert werden, dass zum einen keine agglomerierten Punktdefekte entstehen, weil die dazu notwendige Übersättigung der Punktdefekte nicht erreicht wird, oder zum anderen die entstehenden aggregierten Punktdefekte so klein sind, dass sie nicht messbar und auch nicht für den Bauelementprozess schädlich sind.

Eine solche Kontrolle ist jedoch insbesondere bei der Herstellung von Halbleiterscheiben aus Silizium mit großen Durchmessern ab 200 mm nur mit erheblichen Schwierigkeiten zu realisieren, weil wegen der Abhängigkeit des axialen Temperaturgradienten G von der radialen Position r ein nur schmales Prozessfenster zur Verfügung steht, innerhalb dessen sich v/G bewegen darf.

Wie eine genaue Rechnung auf der Basis der Voronkov-Formeln zeigt, ist der v/G Bereich, in dem es in den leerstellenreichen Gebieten zu keiner Agglomeration von Leerstellen kommt, extrem eng und damit technisch nicht zugänglich.

Eine analoge Betrachtung gilt für die B-Defekte auf der Silizium -Zwischengitteratome (Si-Interstitial) reichen Seite. Lediglich die Bildung von Lpit's kann über einen größeren V/G Bereich vermieden werden, weil dafür eine kritische Größe der Interstitialaggregate überschritten werden muss.

Ein zusätzliches Problem besteht darin, dass der aktuelle radiale Verlauf des Verhältnis von v/G nicht während des Kristallziehens empirisch ermittelt werden kann.

Der Gradient G hängt zudem von dem Zustand der Einbauten der Kristallziehanlage ab. Die Einbauten in der Kristallziehanlage (zum Beispiel Bauteile aus Graphit, Quarz oder Filz) erfahren zum Beispiel eine Veränderung der thermischen Leitfähigkeit oder/und optischen Reflexion, so dass auch die radiale Verteilung des Gradienten G eine Veränderung erfährt, was sich auf das Verhältnis von v/G auswirkt. Diese Veränderungen können dazu führen, dass ein Kristall in der Ziehanlage gezogen wird, die an ihn gestellten qualitativen Anforderungen gestellt wird genügt und der danach gezogene Kristall -obwohl keine baulichen Änderungen durchgeführt wurden, den Anforderungen nur noch teilweise, oder nicht mehr genügt.

Durch eine geringe Veränderung der Ziehgeschwindigkeit kann diesem Effekt entgegengewirkt werden. Dies erfordert in der Regel einen manuellen Eingriff in die Rezeptdaten. Wird anhand der Messdaten festgestellt, dass an einer bestimmten axialen Position das Verhältnis v/G zu groß war, wird die Ziehgeschwindigkeit verringert und umgekehrt. Um welchen Wert jedoch die Korrektur der Ziehgeschwindigkeit stattfinden soll, liegt dabei in der Erfahrung des jeweiligen Operators. Trotz sehr hohen Ausbildungsgrads der Operatoren werden jedoch immer Kristalle gezogen, die eine zu geringere Ausbeute hinsichtlich Defekte, die durch zu hohes oder zu niedriges Verhältnis von v/G entstehen.

Aufgabe der vorliegenden Erfindung ist es, ein System bereitzustellen, das ohne manuellen Eingriff eine bessere Ausbeute bezüglich der Defekte, die durch das Verhältnis von v/G verursacht werden, erreichen kann.

Ebenfalls Aufgabe der vorliegenden Erfindung ist, die Verwendung dieses Systems, um entsprechende Kristalle zu ziehen.

Die Aufgabe wird gelöst durch die in den Ansprüchen beschriebenen Verfahren.

### Detaillierte Beschreibung erfindungsgemäßer Ausführungsbeispiele

Es wurden jeweils mehrere Kristalle aus Silizium aus einem Tiegel mittels des Ziehverfahrens nach Czochralski mit einem Nenndurchmesser von 300 mm gezogen, mit dem Ziel Kristalle herzustellen, die definierte Kristalleigenschaften bezüglich Kristalldefekte aufweisen.

Dabei wurde der Verlauf der Ziehgeschwindigkeit in Abhängigkeit der gewünschten Defektverteilung intrinsischer Punktdefekte vorgegeben und dabei die bekannte Tatsache berücksichtigt, dass das Verhältnis von Ziehgeschwindigkeit v und axialem Temperaturgradienten G an der Phasengrenze zwischen der Schmelze und dem Einkristall diese Defektverteilung maßgeblich beeinflusst. Darüber hinaus wurde der Einfluss von Spannungsfeldern im Einkristall auf Punktdefekte und deren Bewegung berücksichtigt, ebenso wie den von Temperaturfeldern im Einkristall auf die radiale Diffusion von Punktdefekten. Wie das geschehen kann, ist beispielsweise in US 2008/0187736 A1 beschrieben. Der radiale Verlauf des axialen Temperaturgradienten G an der Phasengrenze zwischen der Schmelze und dem Einkristall während des Ziehens des zylindrischen Abschnitts des Einkristalls wird dabei vorab vorzugsweise mittels Simulationsrechnungen ermittelt.

Auch die WO 98/45508 A1 ist eine von zahlreichen Veröffentlichungen, die beschreiben, wie der zeitliche Verlauf der Ziehgeschwindigkeit v experimentell ermittelt werden kann, um über die Kontrolle der Ziehgeschwindigkeit v zu erreichen, dass der Quotient v/G während des Wachstums des Einkristalls nahezu unverändert bleibt und der Einkristall in einem vorgesehenen Gebiet wachsen kann. Darüber hinaus sind Nachweismethoden zur Charakterisierung und Unterscheidung von Pᵥ - Gebiet und Pᵢ -Gebiet beschrieben.

Beim Kristallziehen wurden aus dem Stand der Technik bekannte Mittel eingesetzt, um defektfreie Kristalle herzustellen. Dies kann prinzipiell entweder mit einem CUSP Magnetfeld, einem horizontalen Magnetfeld oder mit einem magnetischen Wanderfeld erfolgen. Ferner werden hierfür die Kristalldrehung und Tiegeldrehung entsprechend eingestellt.

Es wurde dabei zunächst mit den bekannten Mitteln des Standes der Technik eine Vorgabekurve (Basisrezept), die durch entsprechende Stützstellen repräsentiert wird, ermittelt, mit dem es theoretisch in der Lage ist, Kristalle zu ziehen, die den grundlegenden Qualitätsanforderungen genügen.

Die Stützstellen der Vorgabekurve werden dabei als Funktion der Zeit oder bevorzugt als Funktion der Länge des Kristalls angegeben.

Die Erfinder stellten dabei jedoch fest, dass die verwendeten Anlagen zum Kristallziehen zum einen individuelle statische Eigenschaften und zum anderen auch individuelle zeitlich abhängige Eigenschaften aufweisen, die die Eigenschaften des jeweils gezogenen Kristalls beeinflussen, obwohl jeweils dasselbe Basisrezept verwendet wurde.

Unter Eigenschaften der Kristalle wird verstanden, ob ein Kristall oder Teile eines Kristalls Pᵥ -Gebiete und/oder Pᵢ -Gebiete aufweisen, oder ob entsprechende Kristalle oder Teile von Kristallen Gebiete enthalten, die aggregierte Leerstellen in Form von COPs, aggregierte Zwischengitteratome in Form von LPits oder BMDs in einer bestimmten Größe und Dichte enthalten. Entsprechende Messmethoden hierfür sind zum Beispiel in WO 98/45508 A1 beschrieben.

Das vorrangige Ziel besteht hierbei darin, den Prozess innerhalb eines so genannten Prozessfensters zu halten, d. h. zum Beispiel in einem Bereich von v/G, in dem die Abweichungen innerhalb von zulässigen Grenzen bleiben. Da der thermische Gradient G des Kristalls nicht während des Kristallziehens messbar ist, wurde als Maß, ob sich ein Kristall oder Teil eines Kristalls in dem zulässigen Gebiet von v/G befindet oder nicht, die oben genannten Messungen verwendet.

Unterschiedliche statische Eigenschaften der Kristallziehanlagen verursachen offenbar, dass ein und dasselbe Basisrezept zum Ziehen eines Kristalls unterschiedliche Ergebnisse auf unterschiedlichen Anlagen liefert.

Zeitlich abhängige Eigenschaften einer Kristallziehanlage verursachen, dass ein und dasselbe Basisrezept mehrmals hintereinander auf einer Kristallziehanlage angewandt Kristalle mit unterschiedlichen Eigenschaften erhalten werden.

Die Erfinder schlossen daraus, dass das Basisrezept jeweils kleinen Veränderungen unterworfen werden müsse, um gleiche Eigenschaften bei den Kristallen messen zu können. Die Erfinder haben ferner erkannt, dass die Änderung des Basisrezeptes beim Parameter "Ziehgeschwindigkeit vₚ" vorteilhaft ist. Diese Veränderungen wurden zunächst manuell durchgeführt.

Problematisch ist dabei, dass die Eigenschaften eines Kristalls erst nach dessen Fertigstellung gemessen werden können und daher kein entsprechender korrektiver Eingriff während des Kristallziehens möglich ist. In den meisten Fällen betrifft dies sogar einen darauffolgenden Kristall, da die Messung und deren Auswertung nicht immer zeitnah erfolgen kann. Dies lässt daher ein gewisses Mindestmaß an "Ausschuss" erwarten.

Die Erfinder haben alle manuellen Eingriffe bezüglich der Ziehgeschwindigkeit (in Form von Korrekturwerten der Ziehgeschwindigkeiten) für alle gezogenen Kristalle auf allen dafür vorgesehenen Anlagen zusammen mit den experimentellen Ergebnissen in einer Datenbank gespeichert.

Die Erfinder haben ferner alle für den jeweiligen Kristallzieh Prozess relevanten Daten von mehr als 1000 gezogenen Kristallen enthaltend die jeweiligen Korrekturen in der Ziehgeschwindigkeit vₚ und die Reihenfolge der gezogenen Kristalle auf den jeweiligen Anlagen verwendet, um ein Modell zu entwickeln, das automatisch Korrekturen der Ziehgeschwindigkeit vorschlägt.

Das Modell wurde mit Hilfe einer Methode des maschinellen Lernens erstellt, wobei der Algorithmus mittels des sogenannten überwachtem Lernens ("supervised learning") trainiert wurde. Als Software hierfür wurde "RapidMiner" verwendet, es kann aber auch jede andere Software, die für diese Aufgabe geeignet ist verwendet werden.

Die Erfinder wandten das so erhaltene Modell an, um das Basisrezept bezüglich der Ziehgeschwindigkeit sowohl an die jeweilige Anlage anzupassen als auch eine mögliche zeitliche Veränderung der Anlage zu kompensieren. Das heißt, mit dem erhaltenen Modell wurden Korrekturen der Ziehgeschwindigkeit v ermittelt, die den jeweiligen Kristallziehanlagen als Vorgabewerte für den nächsten oder den bereits zu ziehenden Kristall übermittelt wurden.

Überaschenderweise zeigte sich, dass die Ausbeute der Kristalle bzw. Kristallstücke, die sich im gewünschten Fenster von v/G befanden und damit die gewünschten Defekteigenschaften aufweisen, höher war als durch eine rein manuelle Korrektur.

Die Ursache des Effektes ist vermutlich darin begründet, dass selbst ein gut ausgebildeter Operator zwar vermag eine qualitative Korrektur (also zum Beispiel eine zu langsame Ziehgeschwindigkeit v) zu erkennen, aber jedoch Schwierigkeiten hat, eine quantitative Korrektur (zum Beispiel um wieviel schneller gezogen werden soll) immer korrekt vorzugeben. Hierbei ist das vorgeschlagene Verfahren überlegen.

Die Erfinder bemerkten ferner, dass es bevorzugt ist, ein weiteres Modell mit den oben genannten Methoden zu erstellen. Dabei wurde darauf geachtet, dass für dieses weitere Modell ein Anteil von Daten von Kristallen vorhanden ist, die mittels des erstem Modells eine Korrektur erfahren haben. Bevorzugt ist dieser Anteil mindestens 20% und maximal 80%, wobei die Anzahl der Kristalle mindestens 1000 beträgt.

Das so ermittelte weitere Modell ist in der Lage die Korrekturwerte noch etwas besser vorherzusagen und damit die Ausbeute noch etwas zu verbessern.

## Patentansprüche

1. Verfahren zum Ziehen eines Kristalls aus Silizium nach dem Czochralski-Verfahren
wobei beim Kristallziehen ein erster Kristall durch das Anwenden einer Vorgabekurve auf einer Kristallziehanlage hergestellt wird
und der hergestellte erste Kristall einer Messung bezüglich Kristalldefekte unterzogen wird
und das Ergebnis der Messung bezüglich Kristalldefekte mit einem gewünschten Messergebnis verglichen wird
und anhand der Abweichung des Ergebnis der Messung von einem gewünschten Messergebnis eine neue Vorgabekurve errechnet wird, die für die Herstellung eines weiteren Kristalls dient,
**dadurch gekennzeichnet, dass** für das Errechnen der neuen Vorgabekurve ein Modell verwendet wird, das durch eine Methode des maschinellen Lernens berechnet wurde.

2. Verfahren nach Anspruch 1, **dadurch gekennzeichnet, dass** die Vorgabekurve die Ziehgeschwindigkeit vₚ des Kristalls als Funktion der Länge des Kristalls repräsentiert.

3. Verfahren nach Anspruch 1, **dadurch gekennzeichnet, dass** die Vorgabekurve die Ziehgeschwindigkeit vₚ des Kristalls als Funktion der Zeit repräsentiert.

4. Verfahren nach Anspruch 2 oder 3, **dadurch gekennzeichnet, dass** die Methode des maschinellen Lernens eine Trainingsphase mit überwachtem Lernen enthält, bei der Daten von mehr als 1000 gezogenen Kristalle verwendet werden, wobei die Daten die jeweilige Korrekturen in der Ziehgeschwindigkeit vₚ, die Messung bezüglich Kristalldefekte und die Reihenfolge der gezogenen Kristalle auf den jeweiligen Kristallziehanlagen enthalten.

## Geänderte Patentansprüche

### Geänderte Patentansprüche gemäss Regel 137(2) EPÜ.

1. Verfahren zum Ziehen eines Kristalls aus Silizium nach dem Czochralski-Verfahren
wobei beim Kristallziehen ein erster Kristall durch das Anwenden einer Vorgabekurve auf einer Kristallziehanlage hergestellt wird
und der hergestellte erste Kristall einer Messung bezüglich Kristalldefekte unterzogen wird
und das Ergebnis der Messung bezüglich Kristalldefekte mit einem gewünschten Messergebnis verglichen wird
und anhand der Abweichung des Ergebnis der Messung von einem gewünschten Messergebnis eine neue Vorgabekurve errechnet wird, die für die Herstellung eines weiteren Kristalls dient,
**dadurch gekennzeichnet, dass** für das Errechnen der neuen Vorgabekurve ein Modell verwendet wird, das durch eine Methode des maschinellen Lernens berechnet wurde und die Vorgabekurve die Ziehgeschwindigkeit vₚ des Kristalls als Funktion der Länge des Kristalls repräsentiert.

2. Verfahren nach Anspruch 1, **dadurch gekennzeichnet, dass** die Vorgabekurve die Ziehgeschwindigkeit vₚ des Kristalls als Funktion der Zeit repräsentiert.

3. Verfahren nach Anspruch 2 oder 3, **dadurch gekennzeichnet, dass** die Methode des maschinellen Lernens eine Trainingsphase mit überwachtem Lernen enthält, bei der Daten von mehr als 1000 gezogenen Kristalle verwendet werden,
wobei die Daten die jeweilige Korrekturen in der Ziehgeschwindigkeit vₚ, die Messung bezüglich Kristalldefekte und die Reihenfolge der gezogenen Kristalle auf den jeweiligen Kristallziehanlagen enthalten.
